# EUROPEAN PATENT APPLICATION

(11) **EP 4 350 976 A1**
(43) Date of publication of application: **10.04.2024**
(21) Application number: 22200295.8
(22) Date of filing: 07.10.2022
(51) Int. Cl.: H02P 23/02, H02P 23/00

(54) **COMPUTER IMPLEMENTED METHOD FOR ESTIMATING A POWER OUTPUT OF AN ELECTRIC MOTOR**

(71) Applicant: ABB SCHWEIZ AG, 5400 Baden (CH)
(72) Inventor: JANNASCH, Steven, 02170 Espoo (FI); ORMAN, Maciej, 32-052 Radziszow (PL); MUKHERJEE, Victor, 01610 Vantaa (FI)
(74) Representative: Maiwald GmbH

(57) **Abstract**

The present invention is directed to a computer implemented method for estimating a power output of an electric motor with at least one magnetic field sensor, comprising:
- providing magnetic field signal data from the magnetic field sensor, wherein the magnetic field sensor is arranged and configured to measure a magnetic field of the electric motor;
- providing magnetic field frequency data based on the magnetic field signal data;
- determining a fundamental harmonic frequency of the supply frequency of the electric motor;
- determining at least one further harmonic frequency of the fundamental harmonic frequency based on the magnetic field frequency data and/or the magnetic field signal data;
- determining a ratio between an amplitude of the at least one further harmonic frequency and an amplitude of the fundamental harmonic frequency ;
- providing reference ratio data describing a relation of a ratio between an amplitude of the at least one further harmonic frequency and an amplitude of the fundamental harmonic frequency and a power output of the electric motor;
- estimating the power output of the electric motor based on the reference ratio data and the determined ratio.

## Description

### FIELD OF THE INVENTION

The present invention relates to a computer implemented method for estimating a power output of an electric motor, a system comprising an electric motor, a use of an estimated power output for controlling an electric motor and a respective computer program element.

### BACKGROUND OF THE INVENTION

Accurate power measurements are important in the field of electric motors. Acquiring accurate power readings enables users to spot possibilities where energy efficiency can be improved by either renewing the electric motor or replacing it. An electric motor is normally designed to achieve its best performance at a nominal point. Most electric motors are designed to run at 50% to 100% of rated load. Maximum efficiency is usually near 75% of rated load. In certain applications, motors are not always operated at its nominal point. As the applied load varies for a given operation, which is often far from the nominal point, a significant part of the energy is lost due to inefficient operation. An accurate output power also provides users with information about the process that the electric motor is driving.

Typically, the output power is estimated by measuring the voltage and current of the electric motor combined with the knowledge of the efficiency of the motor or, alternatively, a torque meter. These sensors are expensive and difficult to install because the installation requires integration into an industrial process. Other methods of measuring the output power of an electric motor, specifically an asynchronous electric motor, include measuring the line frequency and speed of the motor, which can be used to calculate the slip of the motor. The slip can then be used to estimate the output power of the motor by comparing the slip to the nameplate slip.

The slip method has problems in estimating the output power accurately if the nameplate slip or the calculated slip is small. This is because small errors in speed or line frequency estimation cause large errors in calculated slip. Therefore, the output power estimation for motors operating with a small slip has a large error if slip-based power estimation is used. Slip-based power estimation works only for motors that are operating at above 50% of their nominal load because the relationship between slip and power loses its linearity for low loads.

It has now become apparent, due to the wide range of applications, that there is a need to provide means to improve the power output measurement of electric motors.

In view of the above, it is an object of the present invention to provide a better and easier means to improve the power measurement of electric motors. It is in particular an object of the present invention to provide a means to measure the power output of an electric motor without torque, voltage or current sensors.

These and other objects, which become apparent upon reading the following description, are solved by the subject matter of the independent claims. The dependent claims refer to preferred embodiments of the invention.

### SUMMARY OF THE INVENTION

A first aspect of the present invention relates to a computer implemented method for estimating a power output of an electric motor with at least one magnetic field sensor, comprising:
- providing magnetic field signal data from the magnetic field sensor, wherein the magnetic field sensor is arranged and configured to measure a magnetic field of the electric motor;
- optionally, providing magnetic field frequency data based on the magnetic field signal data;
- determining a fundamental harmonic frequency of the supply frequency of the electric motor;
- determining at least one further harmonic frequency of the fundamental harmonic frequency based on the magnetic field frequency data and/or the magnetic field signal data;
- determining a ratio between an amplitude of the at least one further harmonic frequency and an amplitude of the fundamental harmonic frequency;
- providing reference ratio data describing a relation of a ratio between an amplitude of the at least one further harmonic frequency and an amplitude of the fundamental harmonic frequency and a power output of the electric motor;
- estimating the power output of the electric motor based on the reference ratio data and the determined ratio.

First, magnetic field signal data is provided by the magnetic field sensor. The magnetic field signal data is based on magnetic field measurements of the electric motor by the magnetic field sensor. There may be multiple magnetic field sensors, which provide magnetic field data.

The magnetic field may also be described as magnetic flux or magnetic flux density. Therefore, measuring the magnetic field may comprise measuring the magnetic flux .

The magnetic field signal data is then transformed to magnetic field frequency data. The magnetic field frequency data may also be described as magnetic field frequency spectrum.

The magnetic field signal data may also be described as magnetic flux signal data. The magnetic field frequency data may also be described as magnetic flux frequency data or magnetic flux density frequency spectrum.

A fundamental harmonic frequency or first harmonic frequency is derived based on the supply frequency of the electric motor. In this respect, the supply frequency of the electric motor is preferably determined as the fundamental harmonic frequency.

Then, at least one further harmonic frequency is determined based on the fundamental harmonic frequency. In other words, the at least one further harmonic frequency is determined/identified in the magnetic field frequency data or magnetic field frequency spectrum. Alternatively or additionally, the further harmonic frequency may be determined with the help of the magnetic field signal data. Then, no magnetic field frequency data has to be determined. The further harmonic frequency is a different frequency compared to the fundamental harmonic frequency.

Next, the ratio between the amplitude of the at least one further harmonic frequency and the amplitude of the fundamental harmonic frequency is determined. The ratio of said amplitudes correspond to different loads of the electric motor. Therefore, the power output of the electric motor can be estimated by said ratios of the amplitudes.

Then, the reference ratio data directed to said relation of the ratio between the amplitude of the at least one further harmonic frequency and the amplitude of the fundamental harmonic frequency and the power output of the electric motor are provided. Such reference ratio data may be provided by tests or algorithms.

In other words, the present invention uses the distribution of harmonic frequencies in the magnetic field frequency spectrum and their relation to the motor load to estimate a motor power output. To achieve this, the measurement signal of the magnetic field sensor, for example a magnetometer, is transformed to the frequency domain. The supply frequency of the motor may be considered as the fundamental harmonic (first harmonic) of the magnetic field frequency spectrum. The present invention is using the ratio of the amplitudes of different harmonics of the magnetic field frequency spectrum to the amplitude of its fundamental harmonic to estimate the output power of the motor.

In particular, the present invention offers a method of power estimation that is using magnetic field measurements, which can be measured on the outside of the motor. The current and voltage of the motor does not need to be measured.

An advantage of the invention is its ability to provide an accurate power estimation also for large motors with small speed. Compared to standard systems, this method works without classic sensors such as current, voltage, or torque sensors that are typically expensive solutions and difficult to implement.

In an embodiment, the magnetic field signal data is transformed to magnetic field frequency data by Fast Fourier Transformation. Other methods may be possible. The Fast Fourier Transformation is a well-known method for transforming data from its original domain, for example time, to a representation in the frequency domain.

In an embodiment, the magnetic field sensor is arranged outside and at a radial distance from the electric motor. More precisely, the magnetic field sensor is located near the electric motor in a radial distance to its center longitudinal axis. The advantage of arranging the magnetic field sensor outside of the electric motor is that the sensor may be easier to install. Alternatively, the magnetic field sensor may be arranged inside the electric motor.

In an embodiment, the further harmonic frequency is the third harmonic frequency. The third harmonic frequency provides a signal that is proportional to the power output of the electric motor. Therefore, the third harmonic frequency is very advantageous. Alternatively or additionally, other harmonic frequencies may be possible.

In an embodiment, two or more harmonic frequencies and the respective ratios between the amplitudes of the two or more harmonic frequencies and an amplitude of the fundamental harmonic frequency are determined. The usage of multiple harmonic frequencies and their ratios of the corresponding amplitudes to the amplitude of the fundamental harmonic frequency allows a more accurate and reliable estimation of the power output of the electric motor.

In an embodiment, the reference ratio data is estimated by providing input on actual power output while first measurements are being taken during a test/calibration cycle of the electric motor. Such a test/calibration cycle may comprise different ratio measurements, for example from a low ratio A to a high ratio B. Additionally, the load may be measured for more accurate reference data.

In an embodiment, the reference ratio data is estimated by using a slip-based method for estimating the power output at an operating/nominal point, in particular where the slip-based method provides a maximum of precision. The operation/nominal point is characterized by a stable speed and a stable load.

In an embodiment, the reference ratio data is estimated by using an interpolation from a large amount of data with a slip-based power output and the ratios of the amplitudes at the given slip-based power outputs.

In an embodiment, the method further comprises: controlling an operation point of the electric motor based on the estimated power output.

A further aspect of the present invention is directed to a system comprising an electric motor, a magnetic field sensor and a computing device, wherein the power output of the electric motor is measured with the method according to any one of the above mentioned embodiments.

A further aspect of the present invention is directed to a use of an estimated power output according to any one of the above mentioned embodiments for controlling an operation point of an electric motor.

A further aspect of the present invention is directed to a computer program element, with instructions, which, when executed on a computing device of a computing environment, is configured to execute the steps of the method according to any one of the before mentioned embodiments in a system as mentioned above.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the present invention. The drawings display:
- **Figure 1**: a diagram showing the correlation between the ratio and the motor load;
- Figure 2: a flow chart of an embodiment of the present invention; and
- Figure 3: a system according to an embodiment of the present invention.

### DETAILED DESCRIPTION OF THE EMBODIMENTS

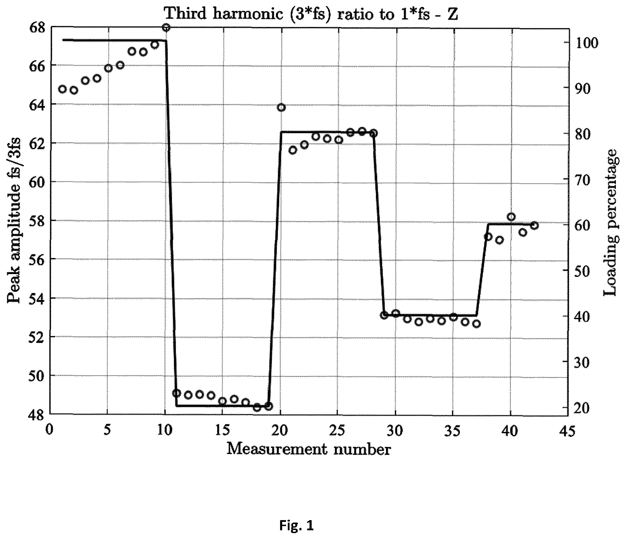

Fig. 1 shows a diagram. The diagram comprises two x-axes and two y-axes. The left y-axis represents the peak amplitude of the ratio of the fundamental harmonic and the third harmonic and the right y-axis represents the corresponding loading percentage of an electric motor. The left y-axis represents the ratio of the third harmonic to the fundamental harmonic and the x-axis represents the measurement number or the number of measurements taken.

The measured peak amplitudes are shown as points. The curve of the loading percentage is shown as a full line.

It is shown in Fig. 1 that there is a clear correlation between the ratio and the motor load/loading percentage. More precisely, the measured peak amplitudes indicate a specific loading percentage of the electric motor. Therefore, by measuring and estimating the peak amplitude of the ratio of the fundamental and the third harmonic, a corresponding motor load and therefore, a power output can be estimated.

In this example, a ratio of 64 to 68 between the measured peak amplitudes corresponds to a loading percentage between 90 and 100%. A ratio between 48 and 50 corresponds to a loading percentage between 20 and 30%, a ratio between 61 and 64 corresponds to a loading percentage of 75 to 85%, a ratio between 52 and 54 corresponds to a loading percentage of 35 to 40% and a ratio between 57 and 59 corresponds to a loading percentage of 55 to 65%. These numbers are only exemplary. These correlation may be calculated/estimated in a more accurate way depending on the number of measurements. Alternatively or additionally, it may be possible to consider other harmonic frequencies and the respective ratios of the amplitudes.

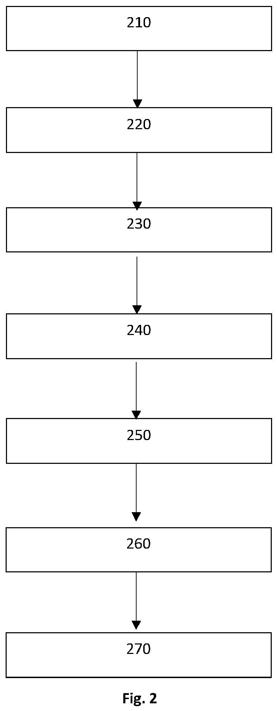

Fig. 2 shows a flow graph of an embodiment of the present invention. In the step 210, magnetic field signal data is provided, for example by a magnetic field sensor. The magnetic field signal data is based on magnetic field measurements of the electric motor by the magnetic field sensor.

In step 220, the magnetic field signal data is then transformed to magnetic field frequency data. The magnetic field frequency data may also be described as magnetic field frequency spectrum.

In step 230, a fundamental harmonic frequency or first harmonic frequency is derived based on the supply frequency of the electric motor. In other words, the supply frequency is in the shown embodiment the first harmonic frequency.

According to step 240, at least one further harmonic frequency is then determined based on the fundamental harmonic frequency. In other words, the at least one further harmonic frequency is determined/identified in the magnetic field frequency data or magnetic field frequency spectrum.

Step 250 comprises that the ratio between the amplitude of the at least one further harmonic frequency and the amplitude of the fundamental harmonic frequency is determined.

In step 260, reference ratio data describing a relation of a ratio between an amplitude of the at least one further harmonic frequency and an amplitude of the fundamental harmonic frequency and a power output of the electric motor is provided. Such reference ratio data may be provided by tests or algorithms.

For example, the reference ratio data may be estimated by providing input on actual power output while measurements are being taken during a test/calibration cycle of the electric motor. During such a calibration cycle, different amplitudes may be tested.

Alternatively or additionally, the reference ratio data may be estimated by using a slip-based method for estimating the power output at an operating point, in particular where the slip-based method provides a maximum of precision.

Further alternatively or additionally, the reference ratio data may be estimated by using an interpolation from a large amount of data with a slip-based power output and the ratios of the amplitudes at the given slip-based power outputs. The ratio of said amplitudes correspond to different loads of the electric motor. The slip method for estimating a motor load is recommended when only operating speed measurements are available. The synchronous speed of an induction motor depends on the frequency of the power supply and on the number of poles for which the motor is wound. The higher the frequency, the faster a motor runs. The more poles the motor has, the slower it runs. The motor speed may be measured for example by using a tachometer.

The reference ratio data may be provided by a cloud or a network. The reference ratio data may be calculated/estimated in the cloud and/or stored in the cloud. It is possible, that reference ratio data for different electric motors may be stored in the cloud or the network such that the right reference ratio data for a specific electric motor is accessible, when needed.

In step 270, the power output of the electric motor based on the reference ratio data and the determined ratio is estimated.

In the following, a summary of the preferred embodiment and advantages of the present disclosure is provided and explained:
In an embodiment of the present invention, the distribution of harmonic frequencies in the magnetic field frequency spectrum and their relation to the motor load is used to estimate a motor power output. To achieve this, the measurement signal of the magnetic field sensor, for example a magnetometer, is transformed to the frequency domain, for example by applying the discrete Fast Fourier Transformation (FFT). The signal in the frequency domain may also be referred to as the magnetic field frequency spectrum. The supply frequency of the motor may be considered as the fundamental harmonic (first harmonic) of the magnetic field frequency spectrum. While the ratios of harmonics provide a clear indication of changes in the load, the ratios alone cannot provide an output power value without initial calibration/reference ratio data. Calibration/Reference ratio data can be provided in multiple ways, e.g.:

Manual calibration by providing input on actual power at the same time while first measurements is being taken.

Using power estimated values from a slip-based method at the operating point when the slip-based method provides maximum precision. That means stable speed and stable load at 100% of a nominal value.

Using an interpolation from a large amount of data with a slip-based output power and the ratios at the given slip-based output powers.

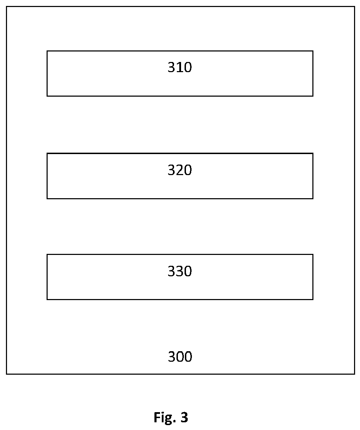

Fig. 3 shows an embodiment of a system 300 according to the present invention comprising an electric motor 310, a magnetic field sensor 320 and a computing device 330. The shown systems is configured to execute the above described method for estimating the power output of an electric motor with the at least one magnetic field sensor 320.

Any disclosure and embodiments described herein relate to the computer implemented method, the system, the use and the computer programmable element lined out above or below and vice versa. The benefits provided by any of the embodiments and examples equally apply to all other embodiments and examples and vice versa.

It shall be noted that all embodiments of the present disclosure concerning the method might be carried out with the order of the steps as described, nevertheless this has not to be the only and essential order of the steps of the method. The herein presented methods can be carried out with another order of the disclosed steps without departing from the respective method, unless explicitly mentioned to the contrary.

Other variations to the disclosed embodiments can be understood and effected by those skilled in the art in practicing the present invention, from the study of the drawings, the disclosure, and the appended claims. In the claims, the word "comprising" does not exclude other elements or steps and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope of the claims.

## Claims

1. Computer implemented method for estimating the power output of an electric motor with at least one magnetic field sensor, comprising:
- providing magnetic field signal data from the magnetic field sensor, wherein the magnetic field sensor is arranged and configured to measure a magnetic field of the electric motor;
- providing magnetic field frequency data based on the magnetic field signal data;
- determining a fundamental harmonic frequency of the supply frequency of the electric motor;
- determining at least one further harmonic frequency of the fundamental harmonic frequency based on the magnetic field frequency data and/or the magnetic field signal data;
- determining a ratio between an amplitude of the at least one further harmonic frequency and an amplitude of the fundamental harmonic frequency;
- providing reference ratio data describing a relation of a ratio between an amplitude of the at least one further harmonic frequency and an amplitude of the fundamental harmonic frequency and a power output of the electric motor;
- estimating the power output of the electric motor based on the reference ratio data and the determined ratio.

2. Method according to claim 1, wherein the magnetic field signal data is transformed to magnetic field frequency data by Fast Fourier Transformation.

3. Method according to claim 1 or 2, wherein the magnetic field sensor is arranged outside and at a radial distance from the electric motor.

4. Method according to any of the preceding claims, wherein the further harmonic frequency is the third harmonic frequency.

5. Method according to any of the preceding claims, wherein two or more harmonic frequencies and the respective ratios between the amplitudes of the two or more harmonic frequencies and an amplitude of the fundamental harmonic frequency are determined.

6. Method according to any of the preceding claims, wherein the reference ratio data is estimated by providing input on actual power output while first measurements are being taken during a test/calibration cycle of the electric motor.

7. Method according to any of the preceding claims, wherein the reference ratio data is estimated by using a slip-based method for estimating the power output at an operating point, in particular where the slip-based method provides a maximum of precision.

8. Method according to any of the preceding claims, wherein the reference ratio data is estimated by using an interpolation from a large amount of data with a slip-based power output and the ratios of the amplitudes at the given slip-based power outputs.

9. Method according to any of the preceding claims, further comprising: controlling an operation point of the electric motor based on the estimated power output.

10. System comprising an electric motor, a magnetic field sensor and a computing device, wherein the power output of the electric motor is measured with the method according to any of the claims 1 to 9.

11. Use of an estimated power output according to any of the claims 1 to 9 for controlling an operation point of an electric motor.

12. Computer program element, with instructions, which, when executed on a computing device of a computing environment, is configured to execute the steps of the method according to any of the claims 1 to 9 in a system according to claim 10.
